# EUROPEAN PATENT APPLICATION

(11) **EP 1 535 880 A1**
(43) Date of publication of application: **01.06.2005**
(21) Application number: 03733023.0
(22) Date of filing: 21.05.2003
(51) Int. Cl.: C01B 21/072, C08K 3/28

(54) **PARTICULATE ALUMINUM NITRIDE AND METHOD FOR PRODUCTION THEREOF**

(30) Priority: 22.05.2002 JP 2002147617
(71) Applicant: JAPAN ENERGY CORPORATION, Tokyo 105-0001 (JP)
(72) Inventor: MORI, Masayuki, c/o Japan Energy Corporation, Toda-shi, Saitama 335-8502 (JP)
(74) Representative: Koepe, Gerd L., Dipl.-Chem.
(86) International application number: PCT/JP2003/006337
(87) International publication number: WO 2003/097527

(57) **Abstract**

A method for producing aluminum nitride includes preparing a slurry containing pseudoboemite and carbon, filtrating and dehydrating the slurry to form a precursor, and calcinating the obtained precursor in an atmosphere containing nitrogen. The slurry is prepared by dispersing a carbon powder in an aqueous solution having a pH adjusted in a range of 8.5 to 9.5, and then synthesizing pseudoboemite by using at least one of an aluminum salt and aluminic acid as an aluminum source, while maintaining the pH of the reaction mixture in a range of 8.5 to 9.5. The aluminum nitrite obtained by the method has a three-dimensional network structure and thus exhibits excellent heat-conducting property and can be suitably used as a filler for an electronic material.

## Description

### TECHNICAL FIELD

The present invention relates to a method for producing aluminum nitride having a three-dimensional network structure by carbothermal reduction-nitridation of a precursor composed of pseudoboehmite having a fibrous structure provided with a carbon source in a uniform manner. In particular, the present invention relates to a method for producing particulate aluminum nitride which is suitable for a filler for a semiconductor package molding compound, and the obtained particulate aluminum nitride.

### BACKGROUND ART

Those well-known as the method for producing aluminum nitride include the direct nitridation and the carbothermal reduction-nitridation. In the direct nitridation, metal aluminum is reacted in a nitrogen atmosphere to directly produce aluminum nitride. On the other hand, in the carbothermal reduction-nitridation, an alumina powder is mixed with a carbon powder or the like as a reducing agent, and the mixture is reacted in a nitrogen atmosphere to produce aluminum nitride. In this method, the product quality is affected by the particle size and the purity of the alumina powder as the raw material, it is possible to produce aluminum nitride having a high purity and a uniform particle size. Therefore, the carbothermal reduction-nitridation is widely used as a method for producing aluminum nitride powder as a raw material for sintered body. The sintered body, which is based on the use of the aluminum nitride as described above, has a high thermal conductivity and high electrical resistivity. Therefore, the sintered body is used, for example, for materials for IC substrates and electronic device packages as well as heat-sinking materials for semiconductor devices.

Several methods have been suggested in relation to the method for producing aluminum nitride, in which no alumina powder is used, and pseudoboehmite, which is one of precursors of alumina powder, is used. Japanese Patent Publication No. 04-60047 (Japanese Patent Application Laid-open No. 63-139008) discloses a method wherein an aluminum nitride powder, in which particles of not less than 1 µm are extremely decreased and the particle size distribution is narrow, is produced by dispersing a pseudoboehmite powder in an acidic aqueous solution of pH 1.2 to 4.5 to prepare a boehmite sol, followed by being solidified, dried, and then calcined in a nitrogen atmosphere. In this method, the boehmite sol is gelated and solidified. Therefore, it is impossible to perform the dehydration by any simple operation such as filtration. The obtained aluminum nitride powder is a particulate powder having fine and uniform particle size which inherits the particle size of the boehmite highly dispersed in the acidic aqueous solution. The obtained aluminum nitride powder is used as a raw material for any sintered body. In general, it is considered to be favorable that the powder, which is to be used for the raw material for the sintered body, has the particulate structure in which the particle size is fine and uniform, for the following reason. That is, the driving force for the sintering is the decrease in the surface energy, i.e., the decrease in the surface area. Therefore, the powder, which has the fine and uniform particle size and which is particulate, has the large surface area so that the surface energy is increased. As a result, the sintering speed is increased, and the powder is easily sintered even at a low temperature. Further, it is easy to obtain the dense sintered body, because the filling density of the powder is increased as well. It is considered that when the particulate powder as described above is sintered, then the sintering is performed uniformly to obtain the dense sintered body, and any three-dimensional network structure is not obtained.

Japanese Patent Application Laid-open No. 63-11506 discloses a method for producing aluminum nitride based on the dry process in which a mixed powder of pseudoboehmite and carbon powder is introduced into an alumina pot together with alumina balls, and the alumina pot is installed in a furnace to thermally treat the mixed powder. The aluminum nitride powder, which is obtained by this method, is characterized in that the specific surface area is large, and the particle size is small and uniform as compared with a powder obtained by using an ordinary alumina powder as a raw material. The aluminum nitride powder is used as a raw material for any sintered body. Also in this case, it is considered that when the obtained powder is sintered, the powder is sintered uniformly to obtain a dense sintered body, and no three-dimensional network structure is obtained, in the same manner as in Japanese Patent Publication No. 04-60047.

Japanese Patent Application Laid-open Nos. 04-65308, 04-59610, and 04-50106 disclose a method in which an alumina powder and a carbon powder are mixed in an aqueous dispersion medium added with a surfactant, and then a heating reaction is effected in an atmosphere containing nitrogen to produce an aluminum nitride powder. For example, Japanese Patent Application Laid-open No. 04-65308 discloses a method in which an alumina powder and a carbon powder are mixed in an aqueous dispersion medium to which a nonionic surfactant is added while adjusting pH to a range between 9 and 13 to obtain a mixed slurry, and then acid is added to the mixed slurry to change pH to a range between 2 and 6. When pH is firstly adjusted to a range between 9 and 13, the carbon powder is highly dispersed in accordance with the action of the nonionic surfactant. Subsequently, the carbon powder is allowed to enter the interstices of the highly dispersed alumina powder by changing PH to a range between 2 and 6. The alumina powder used in this method includes alumina of the generally commercially available grades of low soda alumina, high purity alumina, and reactive alumina. The alumina as described above is different from pseudoboehmite which is a precursor for alumina to be obtained by the neutralization method or the ALFOL method. Each of the low soda alumina and the reactive alumina is an alumina powder obtained by calcinating gibbsite as a precursor produced by the Bayer method. The high purity alumina is an alumina powder obtained by the pyrolysis of alum, the ALFOL method, or the gas phase hydrolysis method (see, for example, "Alumina Powder and Their Prices", Kazuhiko Nakano, Ceramics, 36 (2001), No. 4, pp. 248-253).

It is described that the method as described above makes it possible to obtain aluminum nitride which includes a small amount of coagulated particles, which has a sharp particle size distribution, and which has high sintering performance, by enhancing the dispersibility of both of the alumina powder and the carbon powder by changing pH of the aqueous solution while using the surfactant. However, each of the low soda alumina, the high purity alumina, and the reactive alumina is the finely particulate powder with the uniform particle size. Therefore, it is considered that any aluminum nitride, which has the three-dimensional network structure as in the present invention, is not obtained even when the alumina as described above is sintered.

In recent years, the particulate aluminum nitride is expected to be used for a way of use as the filler for semiconductor package molding compound. Conventionally, spherical silica or the like has been used as the filler for the semiconductor package molding compound. However, in order to successfully dissipate the heat generated in the device, it is demanded to use a filler having high thermal conductivity. Aluminum nitride is expected as a filler material to replace silica, owing to the high thermal conductivity thereof. On the other hand, in the case of the use for the semiconductor package molding compound and the sensor material, it is desirable that the filler is constructed with a high purity aluminum nitride. Therefore, the method, in which the carbon and the alumina powder are dispersed by using the surfactant as described above, is undesirable, because the component of the surfactant remains in the aluminum nitride product.

When the consideration is made about the aluminum nitride for the way of use as the filler, it is required to provide particles having large particle sizes with a high sphericity and a wide particle size distribution of not less than the micron order.

In the case of the direct nitridation described above, the high purity metal aluminum powder is directly heated and nitrided in the nitrogen gas flow. The particle size is relatively large immediately after the nitridation, because the aluminum, which is melted and fused in the nitridation step, is inevitably coagulated. Therefore, in order to obtain particles for the filler, it has been required that the coagulation, which are obtained immediately after the nitridation, are pulverized and classified to obtain particle sizes of several to several tens micron order. However, as a result of the pulverization, the particle shape is angular, non-spherical, and formless. Therefore, problems arise such that the fluidity is lowered, and any impurity easily makes contamination during the repeated pulverizing steps.

In the case of the carbothermal reduction-nitridation described above, the aluminum nitride powder, which has a high purity and a uniform particle size, can be obtained by mixing the high purity alumina powder and the carbon powder and heating in the nitrogen atmosphere. However, this method is basically a method for producing any fine powder for the sintered body. The raw material alumina to be used usually has the sharp particle size distribution of the submicron diameter. As a result, the produced powder also resides in particles of about several microns having a sharp primary particle size distribution of the submicron diameter. Therefore, the produced powder is not suitable for the way of use for the filler.

As described above, in the case of the conventional carbothermal reduction-nitridation and the direct nitridation, it has been difficult to synthesize any aluminum nitride for the filler which has both of the wide particle size distribution and the high fluidity.

Japanese Patent Application Laid-open Nos. 04-50107 and 05-270810 disclose a method in which an aluminum nitride powder is granulated and dried to obtain granular aluminum nitride thereby. In the method described in each of the patent documents, for example, a sintering aid and a solvent are added to the fine aluminum nitride powder to mix them in a wet state, and the mixture is dried and granulated, for example, by using a spray dryer. However, the obtained aluminum nitride is to be used as a raw material for a sintered body. Although the granulated granules have large particle sizes, the granules are merely obtained by drying and coagulating the fine aluminum nitride powder. The thermal conductivity as the bulk is low, because the granules are not any sintered body. Further, in the patent documents described above, the aluminum nitride powder is used as the starting material, and there is no description about the way of production of the aluminum nitride powder.

Japanese Patent Application Laid-open Nos. 04-174910 and 11-269302 disclose a method in which granulated granules are heated at a high temperature to obtain a sintered body having satisfactory thermal conductivity. In the method described in each of the patent documents, a sintering aid and a forming aid are added to an aluminum nitride powder to perform the mixing in a wet state, followed by performing the spray drying to obtain the granulated granules which are sintered at a high temperature in nitrogen. The sintered granules are used as a filler for semiconductor packing molding resins and heat-sinking members composed of silicone rubber. In the patent documents described above, the aluminum nitride powder is used as the starting material, and there is no description about the way of production of the aluminum nitride powder. Further, the method described in each of the patent documents requires a step of producing the aluminum nitride powder, a step of granulating the powder to obtain large particle size granules, and a step of sintering the large particle size granules at a high temperature. The steps, which are required to obtain the sintered body (sintered granules) from the aluminum nitride powder, are complicated, and the cost is expensive. Further, the granulated granules are thermally deposited to one another. Therefore, it is necessary to avoid such an inconvenience. In Japanese Patent Application Laid-open Nos. 04-174910 and 11-269302 described above, a boron nitride powder is added to granulated granules in order to avoid the thermal deposition between the granulated granules. Such an operation also makes the steps to be complicated. A magnified photograph of a spherical sintered granule of aluminum nitride is shown in Japanese Patent Application Laid-open No. 04-174910. However, according to this photograph, the obtained sintered granule resides in a high density particle having a dense structure, which has no three-dimensional network structure.

### DISCLOSURE OF THE INVENTION

A first object of the present invention is to produce spherical aluminum nitride which is excellent in the thermal conductivity and the fluidity by the carbothermal reduction-nitridation of the precursor granulated and dried to have a spherical form. A second object of the present invention is to produce aluminum nitride particles which have a wide particle size distribution favorable for the ways of use as a filler. A third object of the present invention is to produce aluminum nitride without using any organic solvent which is undesirable in view of the environment and any surfactant as a dispersing agent which lowers the product purity.

According to a first aspect of the present invention, there is provided a method for producing aluminum nitride comprising:
preparing a slurry containing pseudoboehmite and carbon;
filtrating and dehydrating the prepared slurry to obtain a precursor; and
calcinating the obtained precursor in an atmosphere containing nitrogen.

In the method of the present invention, the slurry, which contains the finely particulate pseudoboehmite and the carbon source, is granulated to have large particle sizes with ease by selecting the condition of the slurry. The carbon source, which serves as a reducing agent, is dispersed in the precursor granulated to have the objective particle size. Therefore, the carbothermal reduction-nitridation of the precursor is advanced uniformly. Therefore, the aluminum nitride, which has a desired particle size distribution and a desired shape, can be produced in accordance with the convenient steps.

In order to improve the dispersibility of the carbon source, it is preferable that the slurry containing the pseudoboehmite and the carbon is prepared by synthesizing the pseudoboehmite in a solution containing the carbon. In particular, it is preferable that the pseudoboehmite is synthesized by a neutralization reaction in which an aluminum source is at least one of aluminum salt and aluminic acid. During the synthesis, the carbon powder or the like, which serves as a reducing agent, is dispersed while adjusting pH of the aqueous solution in a range of 8.5 to 9.5, and then the neutralization reaction is subsequently performed while adjusting pH in a range of 8.5 to 9.5. Thus, it is possible to form the precursor which includes the carbon source more uniformly and which is composed of fibrous pseudoboehmite.

In the method of the present invention, it is unnecessary to use any surfactant in order to disperse the carbon source and the pseudoboehmite in the aqueous solution. Therefore, the obtained aluminum nitride has a high purity, which is preferably usable, for example, for the way of use for package molding compound for electronic devices. In the method of the present invention, it is also unnecessary to use any organic solvent in order to disperse the carbon source such as carbon black which is hydrophobic.

It is preferable that the temperature of the aqueous solution is maintained in a range of 55 to 75 °C during the synthesis of the pseudoboehmite in order to facilitate the formation of the fibrous pseudoboehmite. It is preferable that the obtained slurry, which contains the precursor, is filtrated and dehydrated to obtain the precursor, and the precursor is granulated to have an average particle size of 5 to 1,000 µm so that the spherical granulated precursor is obtained. When the granulated precursor is calcinated in a nitrogen atmosphere in accordance with the method of the present invention, it is possible to produce the aluminum nitride particle which is spherical and which has the three-dimensional network structure. The spherical aluminum nitride particle provides the high fluidity, and the three-dimensional network structure provides the high thermal conductivity. Therefore, the aluminum nitride is preferably usable for the way of use for the filler.

It is appropriate that the temperature for calcinating particles is such a temperature, for example, 1,300 to 1,600 °C that the carbothermal reduction-nitridation occurs to obtain the aluminum nitride particles. When the calcination is performed at a temperature of the degree as described above, the aluminum nitride particle, which has the three-dimensional network structure, is obtained. Therefore, it is unnecessary to perform the calcination at a high temperature at which the sintering is excessively caused. It is possible to avoid any thermal deposition of aluminum nitride particles.

The granulation operation can be carried out with a spray dryer. It is preferable that the granulation is performed so that 20 to 50 % of all granules exist within a range of ±20 % of the average particle size of the granulated precursor.

According to a second aspect of the present invention, there are provided spherical aluminum nitride particles produced by the production method of the present invention, wherein a three-dimensional network structure is provided in the particle. It is considered that the three-dimensional network structure of the aluminum nitride particles constitutes the heat-sinking passages. When the aluminum nitride particles as described above are used, it is possible to produce a filler which is excellent in the thermal conductivity. It is preferable that the aspect ratio of the fibrous aluminum nitride for constructing the network is not less than 7 in the three-dimensional network structure.

### BRIEF DESCRIPTION OF THE DRAWINGS

Fig. 1 shows particle size distributions of aluminum nitride particles obtained in embodiments of the present invention.
Fig. 2 shows a scanning type electron microscope photograph illustrating an internal structure of the aluminum nitride particle obtained in the embodiment of the present invention.

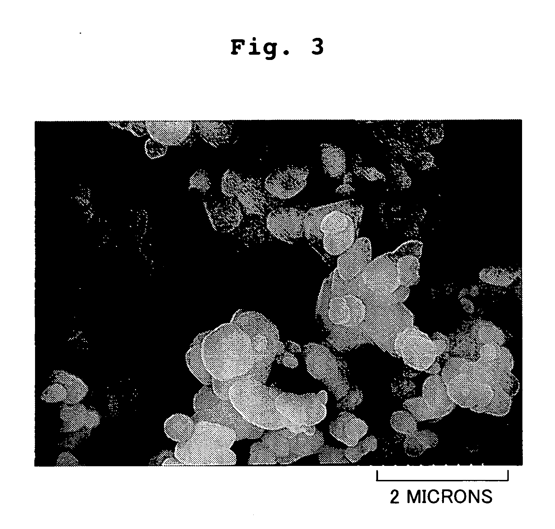

Fig. 3 shows a scanning type electron microscope photograph illustrating an internal structure of the commercially available aluminum nitride particles for any sintered body.
Fig. 4(A) shows a schematic structure of fibrous pseudoboehmite, Fig. 4(B) schematically shows a magnified view illustrating each of fibers composed of the mutually bonded wrinkled sheet, and Fig. 4(C) conceptually shows a situation in which carbon black particles are adhered to the wrinkled sheet.

### BEST MODE FOR CARRYING OUT THE INVENTION

### Pseudoboehmite

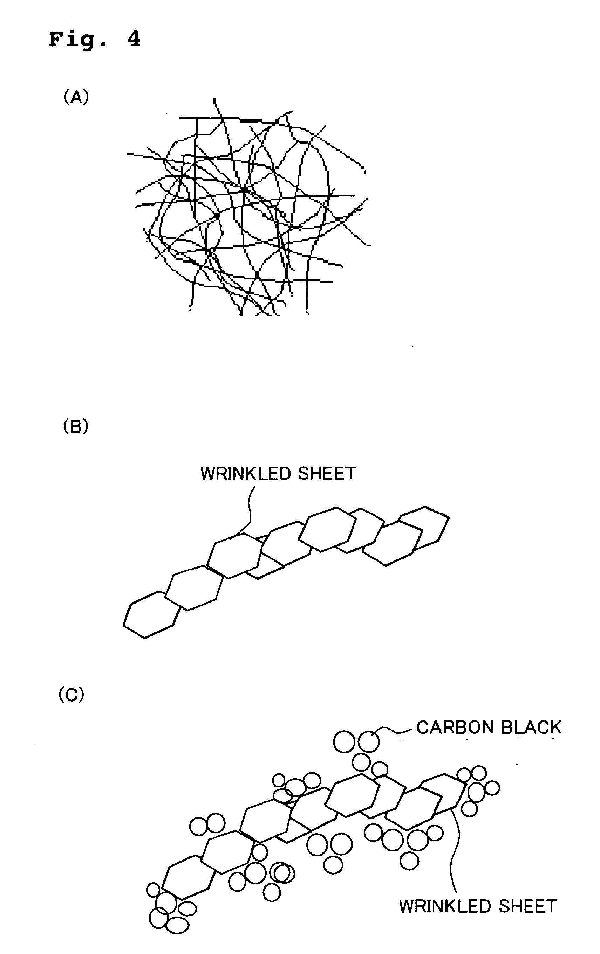

The pseudoboehmite refers to a material having low crystallinity as boehmite which is an aluminum oxyhydroxide. The pseudoboehmite is an alumina hydrate having extra water molecules in the crystals, which is represented by Al₂O₃•xH₂O, wherein x is not less than 1 and less than 2. The X-ray diffraction index of boehmite is described in ASTM Card No. 5-0190. It is preferable to use pseudoboehmite having a (020) plane distance of 6.4 to 6.7 angstroms. It is preferable that the crystallite diameter determined from the width of the (020) diffraction peak is 2.0 to 5.0 nm, and the crystallite diameter determined from the width of the (120) diffraction peak is 2.5 to 7.0 nm. The pseudoboehmite is produced by the neutralization method with aluminum salt and the hydrolysis method with aluminum alkoxide. The pseudoboehmite has such a feature that the dispersibility is high in an acidic aqueous solution. The particulate structure of boehmite is classified into the acicular, the isometrical, the intermediate therebetween, and the wrinkled sheet. In the wrinkled sheet, fine and plate-shaped boehmite primary particles form fibrous aggregate bonded face to face and edge to edge. Fig. 4(A) shows a schematic structure of fibrous pseudoboehmite, and Fig. 4(B) schematically shows a magnified view illustrating each of fibers composed of mutually bonded wrinkled sheets. When the wrinkled sheet-shaped particles are developed, then the agglomerated structure of particles is coarse, and the bulk density is lowered (for example, Journal of the Ceramic Society of Japan, 107 (4), 359-364 (1999)). It is preferable that the pseudoboehmite, which is usable for the method of the present invention, is fibrous pseudoboehmite of the wrinkled sheet type having an aspect ratio of not less than 10 in order to provide the three-dimensional network structure for the aluminum nitride. It is especially preferable that the average aspect ratio is not less than 50.

It is preferable that the pseudoboehmite to be used for the present invention is synthesized in accordance with the neutralization reaction by using an aluminum source of at least one of aluminum salt and aluminic acid. Those preferably usable as the aluminum salt include aqueous solutions of acidic aluminum salts such as aluminum sulfate and aluminum chloride. In this procedure, it is preferable that the aluminum concentration of the acidic aluminum aqueous solution is 0.5 to 3 mol/L. The aluminum concentration of the aqueous aluminic acid solution is preferably 0.3 to 6 mol/L and especially preferably 0.5 to 4 mol/L. The molar ratio of alkali/aluminum is preferably 1 to 3 and especially preferably 1.5 to 2.8. The pseudoboehmite powder can be produced in accordance with the neutralization reaction of aluminum salt and aluminic acid. It is desirable that the temperature of the aqueous solution is controlled during the synthesis of the pseudoboehmite. When the synthesis temperature is 30 to 80 °C, especially 55 to 75 °C, the fibrous precursor is produced with ease. If the temperature is lower than 30 °C, then the structure of the precursor is not fibrous, the structure is approximately particulate, and unreacted matters of acid and alkali tend to remain. The properties of the precursor after the synthesis are unstable, which tend to be changed in a time-dependent manner. If the temperature is higher than 80 °C, it is necessary to respond to the high temperature in relation to the equipment disposed at the lower stages to be used, for example, for the extraction or the drawing of the slurry after the synthesis, the filtration, and the dehydration.

Carbon black is preferably usable as the carbon source. The average particle size of the carbon black is preferably 1 to 1,000 nm and especially preferably 1 to 100 nm. The amount of use of the carbon black is preferably an amount sufficient to reduce the pseudoboehmite. The carbon black is nano-scale fine particles composed of amorphous carbonaceous matter of not less than about 95 %. The carbon black is obtained by treating hydrocarbon in a combustion gas atmosphere at 1,300 to 1,700 °C. The size of the fine particle (basic unit) is about several to several hundreds nm, i.e., the size is fine and minute. However, in general, the fine particles are coagulated to construct the microstructure of several to several tens microns called "structure". As for the carbon source other than the carbon black, it is also allowable to use an organic compound such as hydrocarbon which is converted into carbon by performing the heat treatment in a nitrogen atmosphere. It is preferable that the carbon source is allowed to co-exist in the reaction solution when the pseudoboehmite is synthesized in accordance with the neutralization reaction of aluminum salt and/or aluminic acid. Accordingly, the carbon source and the pseudoboehmite are uniformly dispersed, and the slurry is easily filtrated and dehydrated as well.

In the method of the present invention, the slurry, which contains the pseudoboehmite and the carbon, can be prepared as follows. A predetermined amount of the carbon black is introduced into deionized water having pH adjusted between 8.5 and 9.5, and the carbon black is dispersed for a predetermined period of time. After that, at least one of aluminum salt and aluminic acid as the aluminum source is fed into the aqueous solution while adjusting the flow rate so that pH is between 8.5 and 9.5 to perform the neutralization reaction. As a result of the neutralization reaction, it is possible to form the slurry in which the pseudoboehmite having the fibrous aggregated structure is dispersed. The reason, why pH of the aqueous solution is adjusted between 8.5 and 9.5, is that the feature of the satisfactory dispersibility of the carbon black in the alkali region is intended to be effectively utilized. In this pH region, it is possible to satisfactorily disperse the carbon black in the aqueous solution even when no organic solvent is used. Further, when the neutralization reaction is performed in this pH region, it is possible to obtain the slurry which contains the pseudoboehmite having the fibrous aggregated structure. The slurry can be used to form the precursor composed of the pseudoboehmite having the fibrous structure in which the carbon black is uniformly dispersed. It is considered that the carbon black is adhered to the wrinkled sheets for constructing the fibrous pseudoboehmite as shown in Fig. 4(C). If pH is less than 8.5, it is feared that the dispersibility of the carbon black may be lowered, and any sedimentation and/or any separation may arise. On the contrary, the dispersibility of the pseudoboehmite is enhanced, and the fibrous structure is insufficiently formed.
Simultaneously, the dispersed particles clog up and close the meshes of the filter cloth, and the filterability of the slurry is lowered. On the other hand, if pH exceeds 9.5, then the pseudoboehmite is not generated, the bayerite tends to be formed, and the solubility of the pseudoboehmite is increased. For example, the agitation with mixing impellers or the ultrasonic dispersion may be adopted as the method for dispersing the carbon black added into the deionized water having pH adjusted between 8.5 and 9.5. As for other components, it is also allowable to add, for example, any facilitating agent for nitridation such as calcium carbonate and yttrium oxide to the deionized water.

The specified method of the present invention is different in the following point from the conventional method based on the use of the surfactant as described above (Japanese Patent Application Laid-open Nos. 04-65308, 04-59610, and 04-50106). That is, in the method of the present invention, the pseudoboehmite is not dispersed in the solution. The pseudoboehmite having the fibrous structure is formed while highly dispersing the carbon black in the state in which the solution is controlled to be weakly alkaline.

According to the method of the present invention, the slurry, which is prepared as described above, is filtrated, dehydrated, washed, and formed into a cake which is prepared into the precursor. The filtration, the dehydration, and the washing can be performed in accordance with the standard method based on the use of the belt filter and the filter press. The precursor is calcinated in a non-oxidizing atmosphere containing a nitrogen source such as nitrogen gas and ammonia gas. In order to provide the non-oxidizing atmosphere, it is preferable that the precursor contains the carbon source in such an amount that the oxide such as alumina can be sufficiently reduced. The calcination temperature is preferably 1,200 to 1,700 °C and especially preferably 1,300 to 1,600 °C. The aluminum nitride, which is formed as described above, has the three-dimensional network structure.

In order to produce the spherical aluminum nitride, the following procedure is preferably adopted. That is, the slurry, which contains the pseudoboehmite and the carbon source, is prepared, followed by being filtrated and dehydrated to obtain the precursor. The precursor is granulated to have an average particle size of 5 to 1,000 µm to obtain the spherical granulated precursor. The spherical granulated precursor preferably has an average particle size of 10 to 500 µm and especially preferably 20 to 250 µm. When 20 to 50 % of all granules exist within a range of ±20 % of the average particle size of the granulated precursor, it is possible to obtain the aluminum nitride particles having a wide particle size distribution. Those usable as the method for the granulation include, for example, the mixing granulation method such as the rolling granulation and the fluidized bed granulation, the forcible granulation method such as the compression molding and the extrusion granulation, and the heat-based granulation method such as the melting granulation and the spraying granulation. In particular, the spray drying is preferably used. The spray drying is the method for forming granules belonging to the spray drying granulation method, in which the liquid slurry is finely sprayed in a high temperature gas flow to instantaneously perform the drying.

The aluminum nitride particle, which preferably has an average particle size of 5 to 1,000 µm, especially preferably 10 to 500 µm, and more especially preferably 20 to 250 µm, can be obtained by calcinating the granulated precursor in the non-oxidizing atmosphere containing the nitrogen source such as nitrogen gas and ammonia gas. It is possible to obtain the wide particle size distribution in which 20 to 50 % of all particles exist within the range of ±20 % of the average particle size. The particulate aluminum nitride is substantially spherical, which is usable, for example, for producing the high density formed product and the filling material for heat sinking. In particular, the aluminum nitride is most suitable for the filler for the semiconductor package molding compound.

The precursor is subjected to the carbothermal reduction-nitridation by calcinating the precursor in the non-oxidizing atmosphere containing the nitrogen source. As a result of the carbothermal reduction-nitridation, the three-dimensional network structure of the aluminum nitride is formed. The three-dimensional network structure functions as the passages for the heat during the heat conduction. Therefore, when the calcination is performed at a temperature of such an extent that the aluminum nitride is obtained by the carbothermal reduction-nitridation, the particles having the high thermal conductivity are obtained. Therefore, it is possible to avoid any thermal deposition of particles, which would be otherwise caused by any excessive sintering. The reason, why the aluminum nitride having the three-dimensional network structure is formed when the fibrous pseudoboehmite is used as the precursor, is unknown. Any detailed mechanism has not been proved yet.

The width (diameter) of the fiber (fibrous aluminum nitride) for constructing the three-dimensional network structure of the obtained aluminum nitride is about 0.6 to 0.8 µm in average. The length of the fiber for constructing the network is approximately not less than 5 µm. In order to provide the sufficient thermal conductivity, it is desirable that the aspect ratio of the aluminum nitride fiber for constructing the network is not less than 7 in average.

### EXAMPLES

The present invention will be explained in further detail below with reference to Examples. However, the present invention is not limited to Examples.

### Example 1

4.4 kg of carbon black having an average particle size of 20 nm as a carbon source and 0.5 kg of calcium carbonate as a nitriding aid were introduced while agitating 315 L of ion exchange water introduced into a reaction vessel by using an agitator, followed by being heated to 55 °C while adjusting pH at 8.5. 62 L of aluminum sulfate aqueous solution having an aluminum concentration of 1 mole/L and 123 L of sodium aluminate aqueous solution were heated to 55 °C in separate vessels respectively. After that, the aluminum sulfate aqueous solution and the sodium aluminate aqueous solution were simultaneously introduced into the reaction vessel, followed by being agitated. The aluminum sulfate aqueous solution was fed at a constant feeding rate (3.1 L/minute) so that the feeding time was 20 minutes. During this process, the feeding rate of the sodium aluminate aqueous solution was adjusted so that pH was 8.5 in the reaction vessel. A slurry, which was synthesized as described above, was in an amount of 500 L. The aluminum concentration was 0.37 mole per 1 L of the slurry.

1 L of the synthesized slurry was sampled, and the filterability was confirmed in accordance with the following method. Filter paper (produced by Advantec, No. 3) was placed on a Buchner funnel having a diameter of 110 mm, and the slurry was introduced while effecting the suction with a pump. The time, which was required from the start of the introduction of the slurry to the appearance of cracks in the cake after the disappearance of the filtrate, was measured. As a result, the time was about 1 minute which was short. Thus, the satisfactory filterability was exhibited. The components for constructing the cake were analyzed to be carbon and pseudoboehmite. In particular, it was clarified by the X-ray diffraction measurement that the component was pseudoboehmite. Subsequently, the pseudoboehmite was observed by using a transmission electron microscope (TEM). Ten samples were randomly extracted from the particles existing in the image field. The lengths of the minor axis and the major axis of each of the particles were measured. As a result, the form was fibrous, and the aspect ratio was 12 to 120. The aspect ratio was 65 in average.

The synthesized slurry was fed to a belt filter, followed by being filtrated and dehydrated to obtain a cake. Ion exchange water was sprayed from a position over the filter cloth during the filtration and the dehydration to simultaneously wash out the salt content in the cake. The water content of the obtained cake was measured while effecting the heating to 130 °C by using an infrared moisture meter. As a result, the water content was about 80 %. Ion exchange water was added to the cake to repulp the cake while performing the agitation, and the slurry having a solid concentration of about 10 % was prepared. The slurry was fed into a spray dryer to perform the granulation and the drying by spraying the slurry from an atomizer into the drying chamber. The granulated precursor (aluminum nitride precursor) was obtained as a mixture of the pseudoboehmite and the carbon black. The precursor had an average particle size of 38 µm, and the number of granules included within ±20 % of the average particle size was 40 % of the total. The average particle size was measured by using a laser analysis type particle size distribution measuring apparatus (LA-500) produced by Horiba, Ltd.

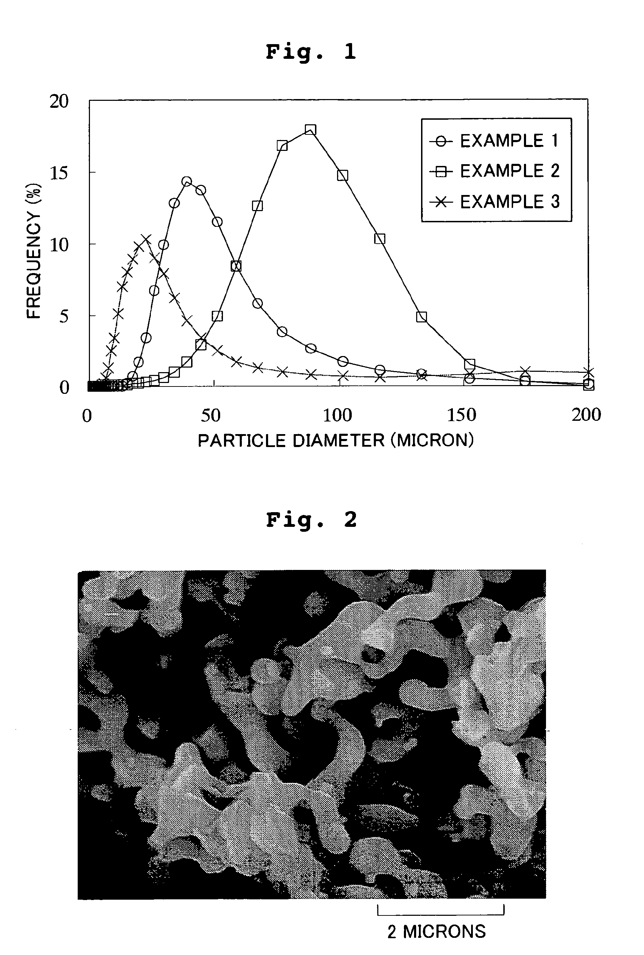

The precursor was calcinated at 1,450 °C for 5 hours in a nitrogen atmosphere, and then a decarbonizing treatment was performed at 700 °C for 3 hours to obtain aluminum nitride particles. The obtained aluminum nitride had an average particle size of 39 µm, and the number of particles included within ±20 % of the average particle size was 41 % of the total. Fig. 1 shows a particle size distribution of aluminum nitride particles. According to Fig. 1, it is appreciated that the aluminum nitride particles, which are obtained in accordance with the method of the present invention, have the wide particle size distribution. The shape was investigated by using a scanning type electron microscope. As a result, it was confirmed that the shape was a clear spherical shape. Further, it was confirmed that the three-dimensional network structure was provided. The structure is shown in Fig. 2. The widths (diameters) of the aluminum nitride fiber for constructing the network structure were about 0.2 µm at thin portions and not less than about 1 µm at thick portions. In average, the diameter was about 0.6 to 0.8 µm. Almost all of the lengths of the fibers for constructing the network were not less than 5 µm, although the lengths were about 2 µm at short branch portions. Therefore, it is affirmed that the aspect ratio of the aluminum nitride fiber for constructing the network is 7.1 in average.

### Example 2

4.4 kg of carbon black having an average particle size of 20 nm as a carbon source and 0.5 kg of calcium carbonate as a nitriding aid were introduced while agitating 315 L of ion exchange water introduced into a reaction vessel by using an agitator, followed by being heated to 60 °C while adjusting pH at 9.0. 62 L of aluminum sulfate aqueous solution having an aluminum concentration of 1 mole/L and 123 L of sodium aluminate aqueous solution were heated to 60 °C in separate vessels respectively. After that, the aluminum sulfate aqueous solution and the sodium aluminate aqueous solution were simultaneously introduced into the reaction vessel, followed by being agitated. The aluminum sulfate aqueous solution was fed at a constant feeding rate (3.1 L/minute) so that the feeding time was 20 minutes. During this process, the feeding rate of the sodium aluminate aqueous solution was adjusted so that pH was 9.0 in the reaction vessel. A slurry, which was synthesized as described above, was in an amount of 500 L. The aluminum concentration was 0.37 mole per 1 L of the slurry.

1 L of the synthesized slurry was sampled, and the filterability was confirmed in accordance with the same method as that used in Example 1. As a result, the time, which was required from the start of the introduction of the slurry to the appearance of cracks in the cake after the disappearance of the filtrate, was about 1 minute. Thus, the satisfactory filterability was exhibited. The components for constructing the cake were analyzed to be carbon and pseudoboehmite. In particular, it was clarified by the X-ray diffraction measurement that the component was pseudoboehmite. Subsequently, the pseudoboehmite was observed by using a transmission electron microscope (TEM) in the same manner as in Example 1. Ten samples were randomly extracted from the particles existing in the image field. The lengths of the minor axis and the major axis of each of the particles were measured. As a result, the following fact was revealed. That is, the form was fibrous, the aspect ratio was 21 to 100, and the average value was 68.

The synthesized slurry was filtrated, dehydrated, granulated, and dried in accordance with the same method as that used in Example 1 to obtain a precursor as a mixture of the pseudoboehmite and the carbon black. The granulated precursor had an average particle size of 76 µm, and the number of granules included within ±20 % of the average particle size was 48 % of the total.

The precursor was calcinated at 1,450 °C for 5 hours in a nitrogen atmosphere, and then a decarbonizing treatment was performed at 700 °C for 3 hours to obtain aluminum nitride particles. The obtained aluminum nitride had an average particle size of 77 µm, and the number of particles included within ±20 % of the average particle size was 49 % of the total. Fig. 1 also shows a particle size distribution in this case. The shape was investigated by using a scanning type electron microscope. As a result, it was confirmed that the shape was a nice spherical shape. Further, it was confirmed that the three-dimensional network structure was provided in the same manner as in Example 1.

### Example 3

4.7 kg of carbon black having an average particle size of 20 nm as a carbon source and 0.35 kg of yttrium oxide as a nitriding aid were introduced while agitating 312 L of ion exchange water introduced into a reaction vessel by using an agitator, followed by being heated at 60 °C while adjusting pH at 9.5. 37 L of aluminum sulfate aqueous solution having an aluminum concentration of 2 mole/L and 150 L of sodium aluminate aqueous solution were heated to 60 °C in separate vessels respectively. After that, the aluminum sulfate aqueous solution and the sodium aluminate aqueous solution were simultaneously introduced into the reaction vessel, followed by being agitated. The aluminum sulfate aqueous solution was fed at a constant feeding rate (1.9 L/minute) so that the feeding time was 20 minutes. During this process, the feeding rate of the sodium aluminate aqueous solution was adjusted so that pH was 9.5 in the reaction vessel. A slurry, which was synthesized as described above, was in an amount of 500 L. The aluminum concentration was 0.45 mole per 1 L of the slurry.

1 L of the synthesized slurry was sampled, and the filterability was confirmed in accordance with the same method as that used in Example 1. As a result, the time, which was required from the start of the introduction of the slurry to the appearance of cracks in the cake after the disappearance of the filtrate, was about 1 minute. Thus, the satisfactory filterability was exhibited. The synthesized slurry was filtrated and dehydrated in accordance with the same method as that used in Example 1 to obtain the cake. The components for constructing the cake were analyzed to be carbon and pseudoboehmite. In particular, it was clarified by the X-ray diffraction measurement that the component was pseudoboehmite. The pseudoboehmite was observed by using TEM in the same manner as in Example 1. As a result, it was revealed that the range of the aspect ratio and the average value thereof were provided as shown in Table 1. In Table 1, the aspect ratios and the average values thereof of the pseudoboehmites obtained in Examples 1 and 2 are also shown in combination.

**Table 1**

| | Aspect | Average value |
|---|---|---|
| Example 1 | 12 to 120 | 65 |
| Example 2 | 21 to 100 | 59 |
| Example 3 | 14 to 145 | 68 |

Ion exchange water was added to the cake to repulp the cake while performing the agitation, and the slurry having a solid concentration of about 1 % was prepared. The slurry was fed into a spray dryer to perform the granulation and the drying by spraying the slurry from an atomizer into the drying chamber. The granulated precursor was obtained as a mixture of the pseudoboehmite and the carbon black. The precursor had an average particle size of 21 µm, and the number of granules included within ±20 % of the average particle size was 30 % of the total.

The precursor was calcinated at 1,450 °C for 5 hours in a nitrogen atmosphere, and then a decarbonizing treatment was performed at 700 °C for 3 hours to obtain aluminum nitride particle. The obtained aluminum nitride had an average particle size of 21 µm, and the number of particles included within ±20 % of the average particle size was 30 % of the total. Fig. 1 also shows a particle size distribution in this case. The shape was investigated by using a scanning type electron microscope. As a result, it was confirmed that the shape was a nice spherical shape. Further, it was confirmed that the three-dimensional network structure was provided in the same manner as in Example 1.

### Example 4

The spherical particles (measured value of void fraction ε = 0.40) having an average particle size of 77 µm obtained in Example 2 is blended with the spherical particles (measured value of void fraction ε = 0.43) having an average particle size of 21 µm obtained in Example 3 to prepare a filler material. The void fraction of the packed bed composed of the two of the large and small particle components was calculated. As a result, it was revealed that the minimum void fraction εmin = 0.3322 was obtained at a mixing partial ratio Sv = 0.25 of the small particles having the average particle size of 21 µm. Therefore, the two types of the particles were blended at a ratio of 0.75 of the particles having the average particle size of 77 µm and a ratio of 0.25 of the particles having the average particle size of 21 µm to obtain a filler material of 80 parts by weight. The material was blended with 20 parts by weight of novolac epoxy resin. The coefficient of thermal conductivity of the resin was measured by using a thermal constant-measuring apparatus based on the laser flash method (produced by Rigaku Corporation). For the purpose of comparison, the coefficient of thermal conductivity was measured in the same manner as described above for a case in which 80 parts by weight of fused silica as a conventional filler material was blended as a filler with 20 parts by weight of novolac epoxy resin. Results of the measurement are shown in Table 2. It was confirmed that the filler, which was formed of the aluminum nitride of the present invention, had the high coefficient of thermal conductivity of the resin and the filler was excellent in the heat-sinking performance as compared with the filler composed of the conventional fused silica. The filler material of the present invention is spherical, and the filler material has the high fluidity. Therefore, it is possible to improve the coefficient of thermal conductivity by effecting the filling at a higher density. In order to prevent the filler from being hydrolyzed, it is also preferable that a coating is further applied to the obtained filler to avoid any hydrolysis.

**Table 2**

| | Coefficient of thermal conductivity (W/mk) |
|---|---|
| Aluminum nitride | 4.5 |
| Fused silica | 0.5 |

### INDUSTRIAL APPLICABILITY

According to the method for producing the aluminum nitride of the present invention, it is possible to produce the spherical aluminum nitride particle which is excellent in the thermal conductivity and the fluidity, in accordance with the simple steps at low cost. In the method for producing the aluminum nitride of the present invention, the feeding of the carbon source, the aluminum salt, and the aluminic acid and the extraction or drawing of the formed slurry are continuously performed in the neutralization reaction step, or the formed slurry is once received by providing the tank at the downstream of the neutralization reaction tank, and thus the aluminum nitride precursor can be continuously produced. Therefore, the method for producing the aluminum nitride of the present invention is excellent in the productivity. In the method for producing the aluminum nitride of the present invention, it is unnecessary to use any surfactant and any organic solvent in order to disperse the carbon source. Therefore, the method for producing the aluminum nitride of the present invention is excellent in view of the environment as well. The high purity aluminum nitride is obtained.

The aluminum nitride produced by the method of the present invention has the spherical form excellent in the fluidity, which has the wide particle size distribution and which has the three-dimensional network structure. Therefore, the aluminum nitride produced by the method of the present invention is excellent in the thermal conductivity. Therefore, the aluminum nitride produced by the method of the present invention is preferably usable as the filler for electronic materials and the porous member, for example, for sensor materials and adsorbing agents.

## Claims

1. A method for producing aluminum nitride comprising:
preparing a slurry containing pseudoboehmite and carbon;
filtrating and dehydrating the prepared slurry to obtain a precursor; and
calcinating the obtained precursor in an atmosphere containing nitrogen.

2. The method for producing the aluminum nitride according to claim 1, wherein the pseudoboehmite is fibrous pseudoboehmite having an aspect ratio of not less than 10.

3. The method for producing the aluminum nitride according to claim 1, wherein the slurry containing the pseudoboehmite and the carbon is prepared by synthesizing the pseudoboehmite in a solution containing the carbon.

4. The method for producing the aluminum nitride according to claim 3, wherein the pseudoboehmite is synthesized by a neutralization reaction in which an aluminum source is at least one of aluminum salt and aluminic acid.

5. The method for producing the aluminum nitride according to claim 3, wherein a carbon source is dispersed in an aqueous solution having pH of a range of 8.5 to 9.5 to prepare an aqueous solution containing the carbon, and the pseudoboehmite is synthesized while maintaining pH of the aqueous solution in a range of 8.5 to 9.5.

6. The method for producing the aluminum nitride according to claim 5, wherein the pseudoboehmite is synthesized while maintaining a temperature of the aqueous solution in a range of 55 to 75 °C.

7. The method for producing the aluminum nitride according to any one of claims 1 to 6, further comprising granulating the prepared slurry to have an average particle size of 5 to 1,000 µm.

8. The method for producing the aluminum nitride according to claim 7, wherein the granulation is performed with a spray dryer.

9. The method for producing the aluminum nitride according to claim 7, wherein the granulation is performed so that 20 to 50 % of all granules exist within a range of ±20 % of the average particle size of the precursor.

10. Aluminum nitride particles produced by the production method as defined in claim 1, wherein a three-dimensional network structure is provided in the particle.

11. The aluminum nitride particles according to claim 10, wherein fiber, which constitutes a network of the three-dimensional network structure, has an aspect ratio of not less than 7.

12. The aluminum nitride particles according to claim 10, which are used as a filler for a package molding compound.
